# EUROPEAN PATENT APPLICATION

(11) **EP 4 203 067 A1**
(43) Date of publication of application: **28.06.2023**
(21) Application number: 22207102.9
(22) Date of filing: 14.11.2022
(51) Int. Cl.: H01L 29/66, H01L 29/78, H10B 51/30

(54) **TRANSISTOR DEVICES WITH PEROVSKITE FILMS**

(30) Priority: 21.12.2021 US 202117557119
(71) Applicant: Intel Corporation, Santa Clara, CA 95054 (US)
(72) Inventor: SEN GUPTA, Arnab, Beaverton, 97003 (US); Plombon, John, Portland, 97219 (US); Nikonov, Dmitri, Beaverton, 97007 (US); O'Brien, Kevin, Portland, 97209 (US); Young, Ian, Portland, 97229 (US); METZ, Mathew, Portland, 97229 (US); Lin, Chia-Ching, Portland, 97229 (US); Clendenning, Scott, Portland, 97225 (US); Debashish, Punyashloka, Hillsboro, 97124 (US); Rogan, Carly, North Plains, 97133 (US); Holybee, Brandon, Portland, 97203 (US); Oguz, Kaan, Portland, 97229 (US)
(74) Representative: Goddar, Heinz J.

(57) **Abstract**

Described herein are integrated circuit devices formed using perovskite materials. Perovskite materials with a similar crystal structure and different electrical properties can be layered to realize a transistor or memory device. In some embodiments, a ferroelectric perovskite can be incorporated into a device with other perovskite films to form a ferroelectric memory device.

## Description

### Technical Field

This disclosure relates generally to the field of integrated circuit (IC) structures and devices, and more specifically, to IC structures and devices formed with perovskite films.

### Background

IC devices often include transistors, which are formed from semiconductors, conductors, and dielectric regions. It is advantageous to reduce power consumption of IC devices. For many low-power IC applications, complementary metal-oxide-semiconductor (CMOS) technology is used. Different materials for further reduction of power consumption are being explored.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a cross-sectional view showing an example arrangement of a one transistor one capacitor (1T-1C) memory cell having perovskite films, according to some embodiments of the present disclosure.
FIG. 2 is a cross-sectional view showing an example arrangement of a ferroelectric memory cell having perovskite films, according to some embodiments of the present disclosure.
FIG. 3A and 3B illustrate two example crystal structures, according to some embodiments of the present disclosure.
FIG. 4 is cross-sectional view showing a top-gated device arrangement having perovskite films and source and drain contacts at the bottom of the device, according to some embodiments of the present disclosure.
FIG. 5 is cross-sectional view showing a top-gated device arrangement having perovskite films and source and drain contacts at the top of the transistor, according to some embodiments of the present disclosure.
FIGS. 6A-6B are perspective and cross-sectional views, respectively, of an example transistor implemented as a FinFET with perovskite films, according to some embodiments of the present disclosure.
FIG. 7 is a flowchart illustrating a method for forming an IC device with perovskite films, according to some embodiments of the present disclosure.
FIGS. 8A and 8B are top views of a wafer and dies that include devices formed from perovskite films in accordance with any of the embodiments disclosed herein.
FIG. 9 is a cross-sectional side view of an IC device that may include perovskite films in accordance with any of the embodiments disclosed herein.
FIG. 10 is a cross-sectional side view of an IC device assembly that may include devices formed from perovskite films in accordance with any of the embodiments disclosed herein.
FIG. 11 is a block diagram of an example computing device that may include devices formed from perovskite films in accordance with any of the embodiments disclosed herein.

### Detailed Description

### Overview

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Described herein are IC devices, such as transistors and memory devices, formed from perovskite films, and methods for producing such devices. IC devices include various circuit elements, such as transistors and capacitors, which are formed from semiconductors, conductors, and insulators. In a CMOS transistor, for example, a semiconductor channel is typically formed from silicon. An oxide gate dielectric sits over the silicon, and a metal gate sits over the oxide. Alternate materials for low-power transistor applications are being explored.

As described herein, materials having a perovskite crystal structure can be grown in layers to form transistors or memory devices. Perovskite materials generally have a chemical formula ABX₃, where A and B are ions, and X is an ion that bonds to both A and B. X is often oxygen (O), so the chemical formula may be written ABO₃, where A and B are ions that bond to oxygen. An idealized form of the perovskite structure is cubic, and perovskite materials often have a cubic or near-cubic crystal structure. Some perovskite materials have different structures depending on temperature.

Different perovskite materials have different material properties, e.g., with different structures and different levels of conductance. Some perovskite materials are conductors, some are semiconductors, and some are insulators. Perovskite materials can be deposited as epitaxial thin films on top of other perovskites. For example, pulsed laser deposition, molecular-beam epitaxy, physical vapor deposition (PVD), or sputter deposition may be used to deposit thin films of perovskite materials. Perovskites with similar crystal structures and different electrical properties can be deposited in a stack to realize a transistor. In particular, a conducting perovskite, dielectric perovskite, and semiconducting perovskite with similar structures can be deposited in layers to form a transistor.

Other perovskite materials are ferroelectric. A ferroelectric material is a material that exhibits, over some range of temperatures, a spontaneous electric polarization, i.e., displacement of positive and negative charges from their original position, that can be reversed or reoriented by application of an electric field. Because the displacement of the charges in ferroelectric materials can be maintained for some time even in the absence of an electric field, such materials may be used to implement memory cells. The term "ferroelectric" is said to be adopted to convey the similarity of ferroelectric memories to conventional ferromagnetic memories, despite the fact that there is no iron (Fe) in ferroelectric materials. Ferroelectric memories have the potential for adequate non-volatility, short programming time, low power consumption, high endurance, and high-speed writing. Over the last few years, these types of memories have emerged as promising candidates for many growing applications such as e.g., digital cameras and contactless smart cards. A ferroelectric perovskite can be grown in a layered stack with additional perovskite materials, e.g., a conducting perovskite and a semiconducting perovskite, to form a ferroelectric memory cell.

Another example IC device that can be formed using perovskite films is a capacitor-based memory cell for storing bits of data. The memory cell may include a capacitor for storing a bit value or a memory state (e.g., logical "1" or "0") of the cell, and an access transistor controlling access to the cell (e.g., access to write information to the cell or access to read information from the cell). The access transistor may be formed from perovskite thin film layers, as mentioned above. Such a memory cell may be referred to as a "1T-1C memory cell," highlighting the fact that it uses one transistor (i.e., "1T" in the term "1T-1C memory cell") and one capacitor (i.e., "1C" in the term "1T-1C memory cell"). The capacitor of a 1T-1C memory cell may be coupled to one source or drain (S/D) region/terminal of the access transistor (e.g., to the source region of the access transistor) by a first S/D contact, while the other S/D region of the access transistor may be coupled to a bitline (BL) by a second S/D contact, and a gate terminal of the transistor may be coupled to a word-line (WL) by a gate contact. Various 1T-1C memory cells have, conventionally, been implemented with access transistors being front end of line (FEOL), logic-process based, transistors implemented in an upper-most layer of a semiconductor substrate.

In both ferroelectric and 1T-1C memory cells, the BL and WL are each formed from metal interconnects that are coupled to additional memory cells, and in particular, access transistors of other memory cells. For example, a BL runs along a column of memory cells, and the BL is coupled to one S/D terminal of each of the access transistors in the column of memory cells via an S/D contact. A WL runs along a row of memory cells, and the WL is coupled to the gate of each of the access transistors in the row of memory cells via a gate contact.

More generally, the perovskite films described herein may be implemented in one or more components associated with an IC. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well known features are omitted or simplified in order not to obscure the illustrative implementations.

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. The meaning of "a," "an," and "the" include plural references. The meaning of "in" includes "in" and "on."

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. The terms "substantially," "close," "approximately," "near," and "about," generally refer to being within +/- 20% of a target value. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art. For example, as used herein, a "logic state" of a ferroelectric memory cell refers to one of a finite number of states that the cell can have, e.g. logic states "1" and "0," each state represented by a different polarization of the ferroelectric material of the cell. In another example, as used herein, a "READ" and "WRITE" memory access or operations refer to, respectively, determining/sensing a logic state of a memory cell and programming/setting a logic state of a memory cell. In other examples, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. In yet another example, a "high-k dielectric" refers to a material having a higher dielectric constant (k) than silicon oxide. The terms "oxide," "carbide," "nitride," etc. refer to compounds containing, respectively, oxygen, carbon, nitrogen, etc.

### Example 1T-1C memory cell with perovskite films

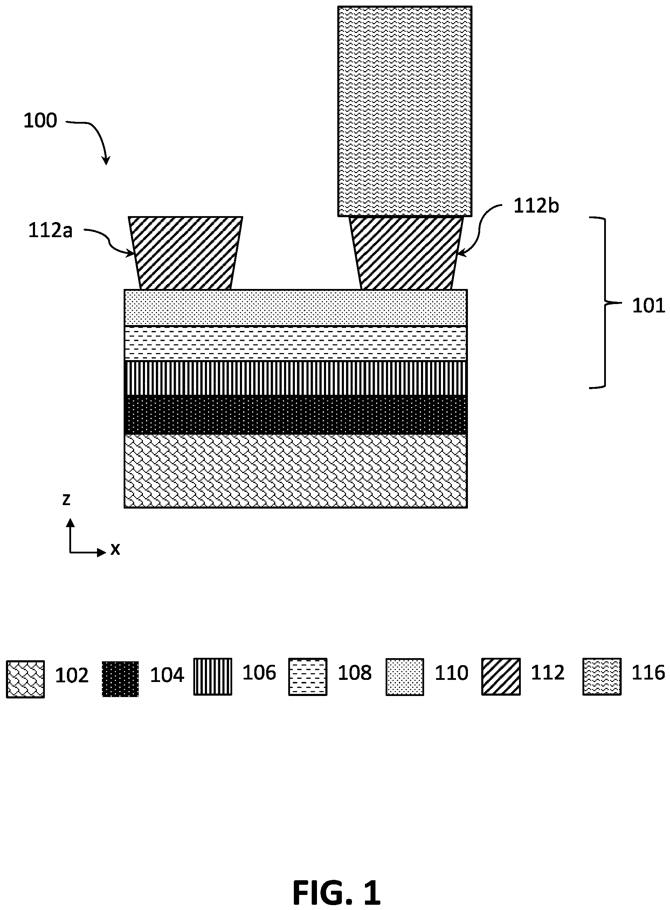

FIG. 1 is a cross-sectional view showing an example arrangement of a 1T-1C memory cell 100 having perovskite films, according to some embodiments of the present disclosure.

A number of elements referred to in the description of FIGs. 1, 2, and 4-6 with reference numerals are illustrated in these figures with different patterns, with a legend showing the correspondence between the reference numerals and patterns being provided at the bottom or side of each drawing page containing FIGs. 1, 2, and 4-6. For example, the legend in FIG. 1 illustrates that FIG. 1 uses different patterns to show a support structure 102, a template layer 104, a gate 106, a dielectric 108, a channel 110, S/D contacts 112, and a capacitor 116.

The 1T-1C memory cell 100 is formed over a support structure 102. The 1T-1C memory cell 100 includes a transistor 101 coupled to a pair of S/D contacts 112a and 112b. One of the S/D contacts 112b is coupled to a capacitor 116 for storing a bit of data. The transistor 101 is an access transistor that controls access to the capacitor 116 to write information to the capacitor 116 or to read information from the capacitor 116.

In the drawings, some example structures of various devices and assemblies described herein are shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

The transistor 101 includes a gate 106, a dielectric 108, a channel 110, and two S/D contacts 112. The gate 106 may be coupled to a WL, e.g., via a gate via not specifically shown in FIG. 1. The WL may be coupled to a row of similar memory cells. The channel 110 may include a first S/D region (not specifically shown in FIG. 1) underneath and coupled to the first S/D contact 112a, and a second S/D region (not specifically shown in FIG. 1) underneath and coupled to the second S/D contact 112b. The first S/D contact 112a may be coupled to a BL that is coupled to a column of similar memory cells. The second S/D contact 112b is coupled to one electrode of a capacitor 116. The capacitor 116 may have a second electrode coupled to a plateline (PL), not shown in FIG. 1, as is known in the art.

In general, implementations of the present disclosure may be formed or carried out on a support structure 102, such as a semiconductor substrate composed of semiconductor material systems including, for example, N-type or P-type materials systems. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. Although a few examples of materials from which the substrate may be formed are described here, any material that may serve as a foundation upon which a semiconductor device may be built falls within the spirit and scope of the present disclosure. In various embodiments the support structure 102 may include any such substrate that provides a suitable surface for providing the memory cell shown in FIG. 1.

The transistor 101 is formed over the support structure 102. In this example, the transistor 101 is formed over a template layer 104, which is formed over the support structure 102. The template layer 104 may be formed from a material with a perovskite structure, e.g., a perovskite oxide having the generic chemical composition ABO₃. The template layer 104 serves as a suitable base for depositing additional perovskite thin films over. In some embodiments, the template layer 104 is grown over the support structure 102 using epitaxial deposition, e.g., pulsed laser deposition, molecular-beam epitaxy, PVD, or sputter deposition. Other layers (e.g., the gate 106, dielectric 108, and channel 110) may be deposited in a similar manner. In other embodiments, the template layer 104 is layer-transferred onto the support structure 102. For example, the template layer 104 is grown on a separate substrate, the template layer 104 is attached to a carrier wafer, the template layer 104 is bonded to the support structure 102, and the carrier wafer is removed from the template layer 104. In other embodiments, the support structure 102 is a perovskite material, and the template layer 104 is not included (i.e., the support structure 102 forms a template layer).

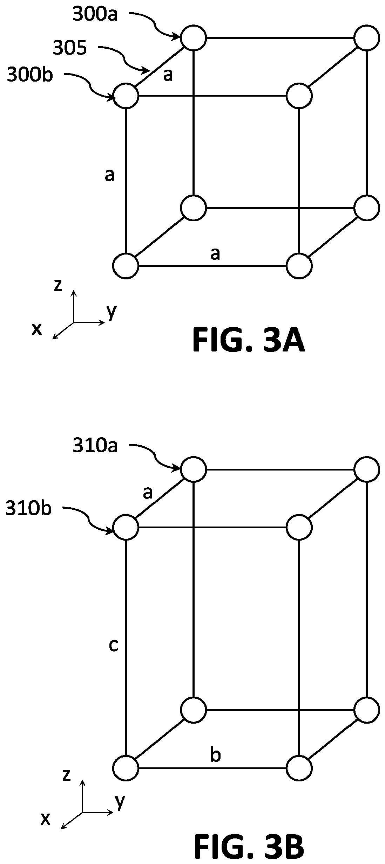

In one example, the template layer 104 is formed from SrTiO₃, also referred to as strontium titanate. SrTiO₃ has a cubic structure with a lattice parameter of 3.905 angstroms (Å). Example crystal structures, including a cubic structure, and lattice parameters are discussed in relation to FIGs. 3A and 3B. In other embodiments, different dielectric perovskite oxides may be used, and in particular, a perovskite oxide with a similar structure to the gate 106.

The gate 106 is a layer (e.g., a thin film) over the template layer 104, and the dielectric 108 is a layer (e.g., a thin film) over the template layer 104. The gate 106 and the dielectric 108 form a gate stack.

The gate 106 is formed of a conductive perovskite material, e.g., a conductive perovskite oxide. The material forming the gate 106 may have a lattice parameter between, e.g., 3.8 and 4.1 Å. The gate 106 may be deposited over the template layer 104 using epitaxial deposition. In an alternate embodiment, the gate 106 may be layer transferred over the template layer 104 or directly over the support structure 102 (omitting the template layer 104).

In one example, the gate 106 is formed from SrRuO₃, also referred to as strontium ruthenate or strontium ruthenium trioxide. SrRuO₃ has a cubic structure with a lattice parameter of 3.987 Å. In another example, the gate 106 is formed from SrVO₃, also referred to as strontium vanadate. SrVO₃ has a cubic structure with a lattice parameter of 3.901 Å. In other embodiments, different conductive perovskite oxides may be used, and in particular, a perovskite oxide with a similar structure to the template layer 104 and the dielectric 108. In some embodiments, the gate 106 may consist of a stack of two or more perovskite layers, e.g., a first layer of SrRuO₃ and a second layer of SrVO₃.

The dielectric 108 may be a high-k material with a perovskite structure, e.g., a nonconductive perovskite oxide. The dielectric 108 is coupled between the gate 106 and the channel 110. The dielectric 108 may have a lattice parameter between, e.g., 3.8 and 4.3 Å. The dielectric 108 may be deposited over the gate 106 using epitaxial deposition. The dielectric 108 may have a thickness measured in the z-direction in the reference coordinate system shown in FIG. 1 between, e.g., 0.5 nanometers and 20 nanometers, including all values and ranges therein (e.g., between 2 and 6 nanometers).

In one example, the dielectric 108 is formed from SrTiO₃, also referred to as strontium titanate. SrTiO₃ has a cubic structure with a lattice parameter of 3.905 Å. In other embodiments, different dielectric perovskite oxides may be used, and in particular, a perovskite oxide with a similar structure to the gate 106 and the channel 110. In some embodiments, the dielectric 108 and the template layer 104 may be formed from the same material. In other embodiments, the dielectric 108 and the template layer 104 are formed from different materials. In some embodiments, the dielectric 108 may consist of a stack of two or more dielectric perovskite layers formed from different materials.

The channel 110 may be formed from a semiconductor material with a perovskite structure, e.g., a semiconductor perovskite oxide. The channel 110 is coupled between the dielectric 108 and the S/D contacts 112. The channel 110 may have a lattice parameter between, e.g., 3.8 and 4.3 Å. The channel 110 may be deposited over the dielectric 108 using epitaxial deposition. The channel 110 may have a thickness measured in the z-direction in the reference coordinate system shown in FIG. 1 between, e.g., 5 and 75 nanometers, including all values and ranges therein.

In one example, the channel 110 is formed from La:SrTiO₃, also referred to as lanthanum-doped strontium titanate, or LST. La:SrTiO₃ has the same structure as SrTiO₃, i.e., a cubic structure with a lattice parameter of at least 3.905 Å. The lattice parameter of La:SrTiO₃ may be larger than 3.905 Å, with the lattice parameter based on the amount of doping. In La:SrTiO₃, the position in the crystal structure where strontium usually sits is filled with lanthanum instead, causing the material to exhibit n-type semiconductor properties. If the dielectric 108 is formed from SrTiO₃ and the channel 110 is formed from La:SrTiO₃, a single layer of SrTiO₃ may be epitaxially deposited over the gate 106, and a top portion of the layer of SrTiO₃ is doped with lanthanum to form the channel 110.

As another example, the channel 110 is formed from BaSnO₃, also referred to as barium stannate or barium tin trioxide. BaSnO₃ has a cubic structure with a lattice parameter of 4.189 Å. In other embodiments, different semiconductor perovskite oxides may be used, and in particular, a perovskite oxide with a similar structure to the dielectric 108. In some embodiments, the channel 108 may consist of a stack of two or more semiconductor perovskite layers formed from different materials.

Each of the template layer 104, the gate 106, dielectric 108, and channel 110 may be perovskites that have similar structures to each other, including similar crystal structures and similar lattice parameters. For example, each may have a similar crystal structure (e.g., cubic or nearly cubic), and have a lattice parameter between 3.8 and 4.3 Å. The materials may be selected so that each of the template layer 104, gate 106, dielectric 108, and channel 110 have perovskite structures with similar lattice parameters, e.g., within 0.5 Å of each other, or within a smaller range of each other (e.g., within 0.3 Å or 0.1 Å). More generally, when a first layer of a first crystalline material is epitaxially deposited over a second layer of a second crystalline material, it is beneficial for the first crystalline material to have a similar structure to the second crystalline material. The similarity of structure helps the first crystalline material form the proper crystal structure when deposited over the second crystalline material. The growing of a first crystalline material over a different, second crystalline material is referred to as heteroepitaxial growth. In some embodiments, the S/D contacts 112 may also be formed from a perovskite with a similar structure and similar lattice parameters to the template layer 104, gate 106, dielectric 108, and channel 110, as discussed below.

Although not specifically shown in FIG. 1, in some embodiments, S/D regions are formed in the channel 110. The S/D regions may be formed using either an implantation/diffusion process or an etching/deposition process. In the former process, dopants such as lanthanum, boron, aluminum, antimony, phosphorous, or arsenic may be ion-implanted into the channel material to form the S/D regions. An annealing process that activates the dopants and causes them to diffuse further into the channel 110 may follow the ion implantation process. In the latter process, the channel 110 may first be etched to form recesses at the locations of the S/D regions. An epitaxial deposition process may then be carried out to fill the recesses with material that is used to fabricate the S/D regions. In some implementations, the S/D regions may be fabricated using a perovskite oxide or other perovskite material.

The S/D contacts 112 are coupled to the channel material 110. If S/D regions are formed in the channel 110, the S/D contacts 112 may be formed over the S/D regions, e.g., the first S/D contact 112a is coupled to the first S/D region, and the second S/D contact 112b is coupled to the second S/D region. An insulator material (not shown in FIG. 1) may be formed between the S/D contacts 112 and electrically separate the two S/D contacts 112a and 112b. The insulator material may be formed as a layer over the transistor 101 and similar transistors, where the insulator material layer further electrically separates transistors from one another. The S/D contacts 112 may be formed in the insulator material by patterning the S/D contacts 112 in the insulator layer and depositing the S/D contact material in the patterned regions.

In some embodiments, the S/D contacts 112 are formed from a perovskite material and epitaxially deposited over the channel 110. For example, the S/D contacts 112 may be formed from SrRuO₃ or SrVO₃, described above with respect to the gate 106. In some embodiments, the S/D contacts 112 and the gate 106 may be formed from the same material. In other embodiments, the S/D contacts 112 may be formed from a different material from the gate 106.

In some embodiments, the S/D contacts 112 may not be formed from a perovskite oxide, or the S/D contacts 112 may have one or more layers of perovskite oxide (e.g., SrRuO₃ or SrVO₃) under one or more layers of other contact materials. For example, one or more layers of metal and/or metal alloys may be used to form the S/D contacts 112. The S/D contacts 112 may include one or more metals or metal alloys, with materials such as copper, ruthenium, palladium, platinum, cobalt, nickel, hafnium, zirconium, titanium, tantalum, and aluminum, tantalum nitride, tungsten, doped silicon, doped germanium, or alloys and mixtures of any of these. In some embodiments, the S/D contacts 112 may include one or more electrically conductive alloys, oxides, or carbides of one or more metals. In some embodiments, the S/D contacts 112 may include a doped semiconductor, such as silicon or another semiconductor doped with an N-type dopant or a P-type dopant. Metals may provide higher conductivity, while doped semiconductors may be easier to pattern during fabrication. In some embodiments, the S/D contacts 112 may include both a semiconductor and a metal, e.g., an atomic layer deposition (ALD)-deposited doped oxide semiconductor followed by metal.

The S/D contacts 112 may have a thickness measured in the z-direction in the reference coordinate system shown in FIG. 1 of between 1 nanometers and 50 nanometers, including all values and ranges therein. In some embodiments, the S/D contacts 112 have a thickness between 30 and 40 nanometers.

As noted above, in FIG. 1, the second S/D contact 112b is coupled to a capacitor 116 to realize a 1T-1C transistor. In some embodiments, the capacitor 116 is omitted, and the transistor 101 may not be an access transistor for a memory cell, but a transistor used for another application.

### Example ferroelectric memory cell with perovskite films

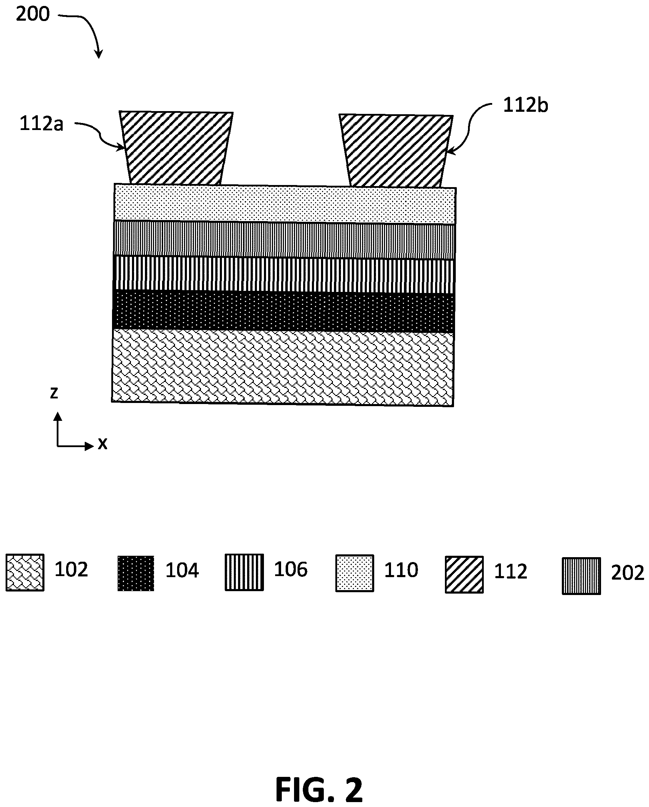

FIG. 2 is a cross-sectional view showing an example arrangement of a ferroelectric memory cell 200 having perovskite films, according to some embodiments of the present disclosure.

The arrangement shown in FIG. 2 may be formed using several of the materials described above with respect to FIG. 1. In particular, the arrangement includes a support structure 102, a template layer 104, a gate 106, a channel 110, and two S/D contacts 112, each of which may be similar to the support structure, template layer, gate, channel, and S/D contacts described above with respect to FIG. 1. The support structure 102 and template layer 104 may or may not be considered part of the memory cell 200. The dielectric 108 shown in FIG. 1 has been replaced with a ferroelectric 202, which is a layer of ferroelectric material that exhibits electric polarization, i.e., displacement of positive and negative charges from their original position. The electric polarization can be reversed or reoriented by application of an electric field. Because the displacement of the charges in ferroelectric materials can be maintained for some time even in the absence of an electric field, the ferroelectric 202 is used to implement a memory cell. In particular, the electric polarization represents a particular bit value or a memory state (e.g., logical "1" or "0") of the memory cell.

The template layer 104, gate 106, channel 110, and S/D contacts 112 may each be formed using the materials described with respect to FIG. 1 and in the manner described with respect to FIG. 1, e.g., using epitaxial deposition.

Each of the template layer 104, the gate 106, ferroelectric 202, and channel 110 may be perovskites (e.g., perovskite oxides) that have similar lattice parameters to each other. For example, each may have a similar crystal structure (e.g., cubic or nearly cubic), and have a lattice parameter between 3.8 and 4.3 Å. The materials may be selected so that each of the template layer 104, gate 106, ferroelectric 202, and channel 110 have perovskite structures with similar lattice parameters, e.g., within 0.5 Å of each other, or within a smaller range of each other (e.g., within 0.3 Å or 0.1 Å). More generally, when a first layer of a first crystalline material is epitaxially deposited over a second layer of a second crystalline material, it is beneficial for the first crystalline material to have a similar structure to the second crystalline material. The similarity of structure helps the first crystalline material form the proper crystal structure when deposited over the second crystalline material. In some embodiments, the S/D contacts 112 may also be formed from a perovskite with a similar structure and similar lattice parameters to the template layer 104, gate 106, ferroelectric 202, and channel 110.

The ferroelectric 202 may be a high-k material with a perovskite structure and ferroelectric properties, e.g., a ferroelectric perovskite oxide. The ferroelectric 202 is coupled between the gate 106 and the channel 110. The ferroelectric 202 may have a lattice parameter between, e.g., 3.8 and 4.3 Å. The ferroelectric 202 may be deposited over the gate 106 using epitaxial deposition.

In one example, the ferroelectric 202 includes BaTiO₃, also referred to as barium titanate. BaTiO₃ has a tetragonal structure with lattice parameters of a=b=4.004 Å and c=4.201 Å. Note that the a and b lattice parameters are fairly close to c, making BaTiO₃ nearly cubic in structure. In another example, the ferroelectric 202 includes lead zirconate titanate, having a chemical formula Pb[ZrₓTi₁₋ₓ]O₃ (0≤*x*≤1), referred to as PZT. PZT has a cubic structure with a lattice parameter in the range of 3.9 to 4.2 Å, depending on the chemical formula. In another example, the ferroelectric 202 includes BiFeO₃, also referred to as bismuth ferrite. BiFeO₃ can be grown as a rhombohedral crystal with an edge length lattice parameter of 3.96 Å and an edge angle lattice parameter of 0.6°, making the structure nearly cubic. In another example, the ferroelectric 202 includes LuFeO₃, also referred to as lutetium ferrite. A ferroelectric LuFeO₃ may have a hexagonal or an orthorhombic structure. In other embodiments, different dielectric perovskite oxides may be used, and in particular, a perovskite oxide with a similar structure to the gate 106 and the channel 110.

### Example Crystal Structures for Perovskite Films

FIG. 3A and 3B illustrate two example crystal structures, according to some embodiments of the present disclosure. FIG. 3A illustrates a cubic crystal structure. In this structure, atoms are represented as dots, e.g., 300a and 300b. The atoms are positioned the corners of a cube, and edges representing lengths between various pairs of atoms are shown. For example, the edge 305 extends between the atoms 300a and 300b. In general, a crystal structure of a perovskite material can be described by six lattice parameters: three representing the edge lengths, and three representing the angles between the cell edges. In cubic and tetragonal structures described herein, all of the angles are 90°. In a cubic structure, each of the edge lengths are equal. For example, in the reference coordinate system shown in FIG. 3A, the edge lengths in the x-direction, y-direction, and z-direction all have a length a. The lattice parameter referred to herein for a cubic structure refers to the edge length. For example, as noted above, SrTiO₃ has a cubic structure with a lattice parameter of 3.905 Å; the 3.905 Å refers to the edge length a.

FIG. 3B illustrates an orthorhombic crystal structure. Atoms in this crystal structure, represented as dots 310 (e.g., dots 310a and 310b), are positioned at the corners of the crystal, and edges representing lengths between certain pairs of atoms are shown. In an orthorhombic crystal structure, the angles between the cell edges are all 90°, but the edge lengths may be different. For example, in the reference coordinate system shown in FIG. 3B, the edge length in the x-direction is a, the edge length in the y-direction is b, and the edge length in the z-direction is c. In a tetragonal crystal structure (such as BaTiO₃), the lengths a and b are equal, and the length c is different from a and b. For an orthorhombic or tetragonal crystal structure, the lattice parameter referred to herein may refer to any of the edge lengths, i.e., a or b or c.

### Alternate transistor arrangements with perovskite films

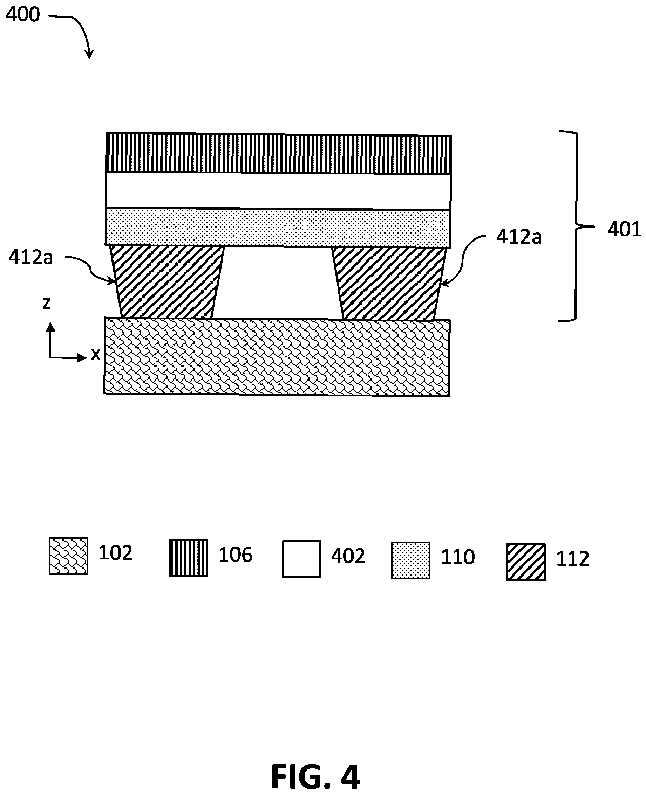

FIGs. 4-6 illustrate three particular examples of alternate transistor arrangements that can be formed from perovskite thin films.

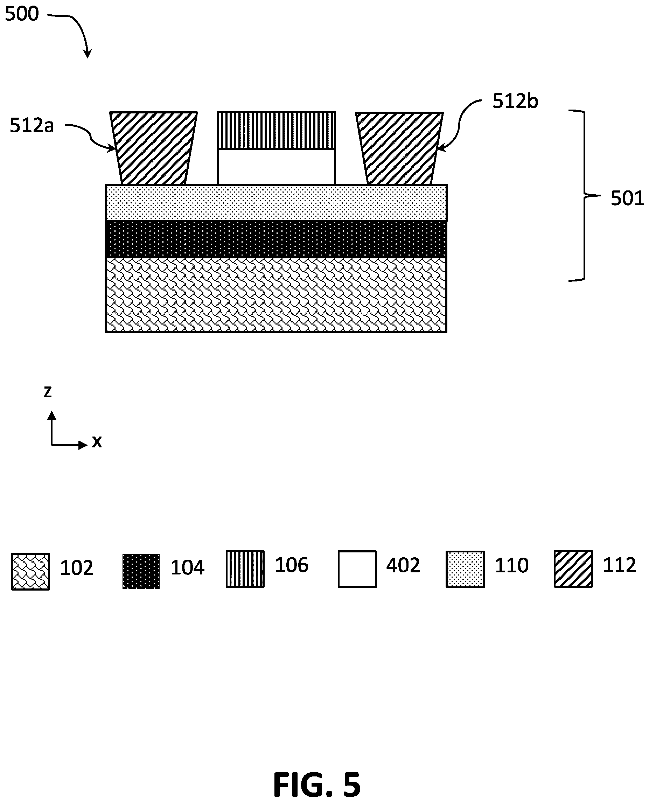

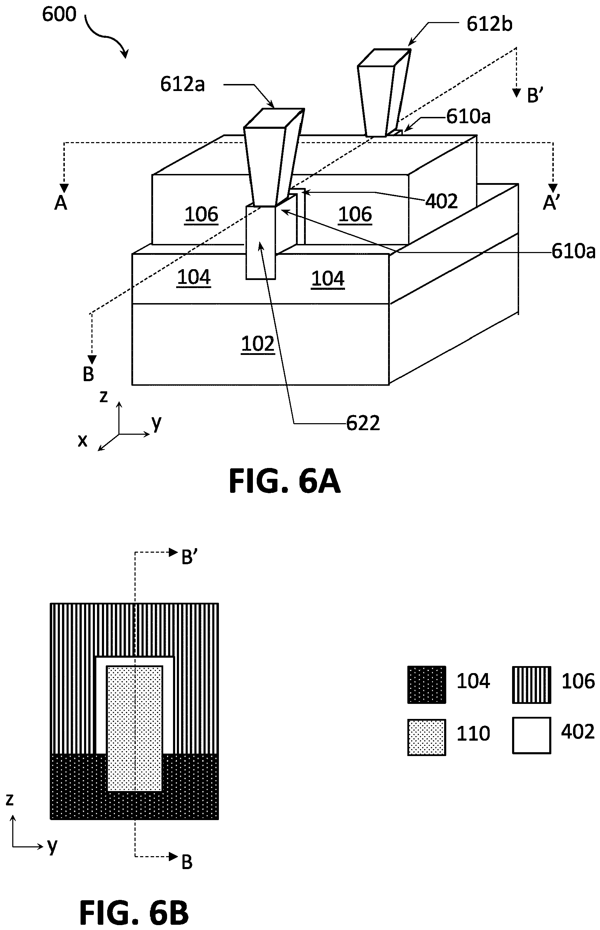

Each of the arrangements shown in FIGs. 4-6 includes some of the components and materials described with respect to FIG. 1, i.e., a support structure 102, a gate 106, a channel 110, and S/D contacts 112. The template layer 104 is shown in FIGs. 5 and 6. In addition, a generalized high-k region 402 is shown in FIGs. 4-6. The high-k region 402 may be a ferroelectric, e.g., the ferroelectric 202 described with respect to FIG. 2, or a high-k dielectric, e.g., the dielectric 108 described with respect to FIG. 1. If the high-k region 402 is a ferroelectric, the arrangement forms a ferroelectric memory cell. If the high-k region 402 is a dielectric, the arrangement forms a transistor. If the arrangement forms a transistor, a capacitor may be coupled to one of the S/D contacts to form a 1T-1C memory cell, as described with respect to FIG. 1.

FIG. 4 is cross-sectional view showing a top-gated device arrangement having perovskite films and source and drain contacts at the bottom of the device, according to some embodiments of the present disclosure. In this example, two S/D contacts 412a and 412b are formed over the support structure 102, the channel 110 is formed over the S/D contacts 412a and 412b, the high-k region 402 is formed over the channel 110, and the gate 106 is formed over the high-k region 402.

As described with respect to FIG. 1, the S/D contacts 412a and 412b may be formed from a perovskite, e.g., SrRuO₃ or SrVO₃. If the S/D contacts 412a and 412b are formed from a perovskite material, the S/D contacts 412a and 412b may be deposited over a template layer (not shown in FIG. 4), which may be similar to the template layer 104 described with respect to FIG. 1. A second, insulating perovskite material may be grown in an area between and/or around the S/D contacts 412a and 412b to serve as a suitable template material for growing the channel 110.

In another embodiment, the channel 110 is layer-transferred over the S/D contacts 412a and 412b. In this embodiment, the S/D contacts 412a and 412b may be formed from a perovskite material or another S/D contact material, such as any of the other materials described with respect to the S/D contacts 112a and 112b in FIG. 1.

As described with respect to FIG. 1, the channel 110 may be formed from a material with a perovskite structure, e.g., La:SrTiO₃ or BaSnO₃. The high-k region 402 is also a perovskite material with a similar structure to the channel 110, and the high-k region 402 can be grown over the channel 110. The gate 106 may also be a perovskite material, e.g., SrRuO₃ or SrVO₃. Alternatively, the gate 106 may be formed from a non-perovskite material, e.g., any of the materials described with respect to the S/D contacts 112 in FIG. 1.

FIG. 5 is cross-sectional view showing a top-gated device arrangement having perovskite films and having S/D contacts at the top of the transistor, according to some embodiments of the present disclosure. In this example, a template layer 104 is formed over the support structure 102, and the channel 110 is formed over the template layer 104. Towards the center of the device in the x-direction, a high-k region 402 is formed over the channel 110, and the gate 106 is formed over the high-k region 402. On the two ends of the device in the x-direction, on either side of the high-k region 402 and the gate 106, two S/D contacts 512a and 512b are formed over the channel 110.

As described with respect to FIG. 1, the template layer 104 may be grown over the support structure 102 or layer-transferred onto the support structure 102. Alternatively, if the support structure 102 has a suitable structure for growing the channel 110 over top of (e.g., the support structure 102 is a perovskite with a similar structure to the channel 110), the template layer 104 may be omitted. As another alternative, the channel 110 may be layer-transferred over the support structure 102. The high-k region 402 is a perovskite material (e.g., any of the materials described with respect to the dielectric 108 or the ferroelectric 202) that is grown over the channel 110. The gate 106 and/or the S/D regions 512a and 512b may also be perovskite materials, such as the perovskite oxides described with respect to the gate 106 and the S/D regions 112. Alternatively, the gate 106 and/or the S/D regions 512a and 512b may be formed from non-perovskite materials, such as the non-perovskite materials described with respect to the S/D regions 112.

FIGS. 6A-6B are perspective and cross-sectional views, respectively, of an example transistor implemented as a FinFET with perovskite films, according to some embodiments of the present disclosure. FinFETs refer to transistors having a non-planar architecture where a fin, formed of one or more semiconductor materials, extends away from a base (where the term "base" refers to any suitable support structure on which a transistor may be built, e.g., a substrate). A portion of the fin that is closest to the base may be enclosed by an insulator material. Such an insulator material, typically an oxide, is commonly referred to as a "shallow trench isolation" (STI), and the portion of the fin enclosed by the STI is typically referred to as a "subfin portion" or simply a "subfin." In the example shown in FIG. 6, the template layer 104 may be an insulator material enclosing the fin. A gate stack that includes at least a layer of a gate material and, optionally, a layer of a dielectric may be provided over the top and sides of the remaining upper portion of the fin (i.e., the portion above and not enclosed by the STI), thus wrapping around the upper-most portion of the fin. The portion of the fin over which the gate stack wraps around is typically referred to as a "channel portion" of the fin because this is where, during operation of the transistor, a conductive channel forms, and is a part of an active region of the fin. Two S/D regions are provided on the opposite sides of the gate stack, forming a source and a drain terminal of a transistor. FinFETs may be implemented as "tri-gate transistors," where the name "tri-gate" originates from the fact that, in use, such transistors may form conducting channels on three "sides" of the fin. FinFETs potentially improve performance relative to single-gate transistors and double-gate transistors.

FIG. 6A is a perspective view, while FIG. 6B is a cross-sectional side view of a FinFET 600 that may be formed using perovskite materials, according to some embodiments of the disclosure. FIGS. 6a-6b illustrate the support structure 102, template layer 104, gate 106, high-k region 402 (e.g., a dielectric 108 or a ferroelectric 202), and channel material 110 as described above. The two S/D contacts, which may be similar to the S/D contacts 112a and 112b, are labeled as 612a and 612b in FIG. 6A. As shown in FIGS. 6A-6B, when the transistor 600 is implemented as a FinFET, the FinFET 600 may further a fin 622. As shown in FIG. 6A and 6B, the template layer 104 may act as an STI material enclosing the subfin portion of the fin 622, or a different STI material may be used. The cross-sectional side view of FIG. 6B is the view in the y-z plane of the example coordinate system x-y-z shown in FIG. 6A, with the cross-section of FIG. 6B taken across the fin 622 (e.g., along the plane shown in FIG. 6A as a plane AA'). On the other hand, the cross-sectional side view of FIG. 5 is the view in the x-z plane of the example coordinate system shown in FIG. 6A with the cross-section taken along the fin 622 for one example portion of the gate stack (e.g., along the plane shown in FIG. 6A and in FIG. 6B as a plane BB').

As shown in FIGS. 6A-6B, the fin 622 may extend away from the support structure 102 and may be substantially perpendicular to the support structure 102. The fin 622 may include one or more semiconductor materials, e.g. a stack of semiconductor materials, so that the upper-most portion of the fin (namely, the portion of the fin 622 enclosed by the gate 106 and high-k region 402) may serve as the channel region of the FinFET 600. Therefore, the upper-most portion of the fin 622 may be formed of the channel material 110 as described above. A lower portion of the fin 622 may be formed of a less conductive material, e.g., the same material as the template layer 104 or another perovskite oxide with a similar crystal structure to the channel material 110.

The gate stack (i.e., the high-k region 402 and the gate 106) may wrap around the upper portion of the fin 622 (the portion above the template layer 104 or other insulating material), as shown in FIGS. 6A-6B, with a channel portion of the fin 622 corresponding to the portion of the fin 622 wrapped by the gate stack as shown in FIGS. 6A-6B. In particular, the high-k region 402 may wrap around the upper-most portion of the fin 622, and the gate 106 may wrap around the high-k region 106. The interface between the channel portion and the subfin portion of the fin 622 is located proximate to where the gate 106 ends.

In some embodiments, the FinFET 600 may have a gate length, GL, (i.e. a distance between the S/D regions formed in the fin 622, or the distance between the S/D contacts 612a and 612b), a dimension measured along the fin 622 in the direction of the x-axis of the example reference coordinate system x-y-z shown in FIG. 5 and FIGS. 6A-6B, which may, in some embodiments, be between about 5 and 40 nanometers, including all values and ranges therein (e.g. between about 22 and 35 nanometers, or between about 20 and 30 nanometers). The fin 622 may have a thickness, a dimension measured in the direction of the y-axis of the reference coordinate system x-y-z shown in FIGS. 6A-6B, that may, in some embodiments, be between about 5 and 30 nanometers, including all values and ranges therein (e.g. between about 7 and 20 nanometers, or between about 10 and 15 nanometers). The fin 622 may have a height, a dimension measured in the direction of the z-axis of the reference coordinate system x-y-z shown in FIGs 6A-6B, which may, in some embodiments, be between about 30 and 350 nanometers, including all values and ranges therein (e.g. between about 30 and 200 nanometers, between about 75 and 250 nanometers, or between about 150 and 300 nanometers).

Although the fin 622 illustrated in FIGS. 6A-6B is shown as having a rectangular cross-section in a y-z plane of the reference coordinate system shown, the fin 622 may instead have a cross-section that is rounded or sloped at the "top" of the fin 622, and the gate stack may conform to this rounded or sloped fin 622. In use, the FinFET 600 may form conducting channels on three "sides" of the channel portion of the fin 622, potentially improving performance relative to single-gate transistors (which may form conducting channels on one "side" of a channel material or substrate) and double-gate transistors (which may form conducting channels on two "sides" of a channel material or substrate).

### Example Method for Forming IC Device with Perovskite Films

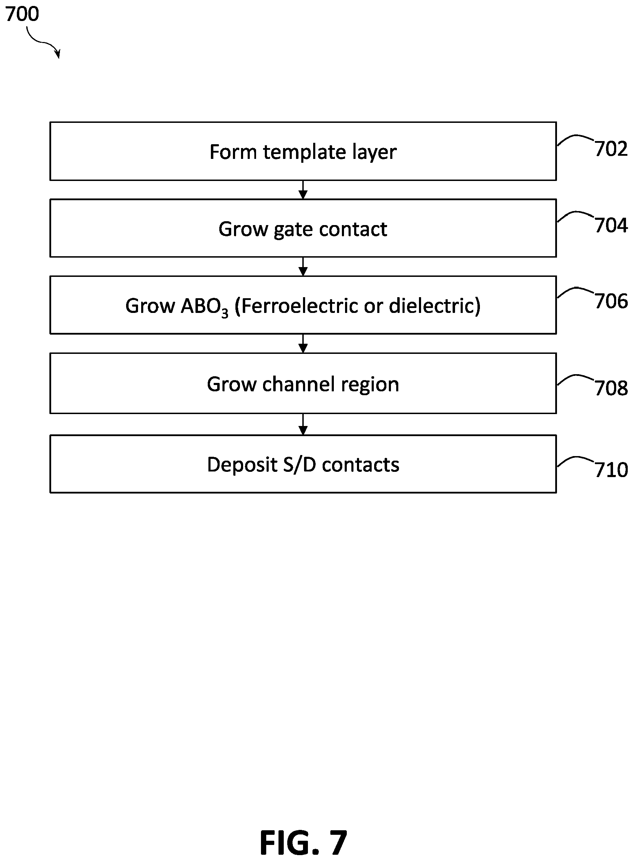

FIG. 7 is a flowchart illustrating a method for forming an IC device with perovskite films, according to some embodiments of the present disclosure. The method begins with forming 702 a template layer, e.g., the template layer 104 shown in FIG. 1 or FIG. 2. The template layer 104 may be formed over a support structure, e.g., the support structure 102. The template layer 104 may be epitaxially deposited or layer-transferred, as described with respect to FIG. 1. In other embodiments, the support structure 102 forms the template layer.

The method proceeds with growing 704 a gate contact, e.g., the gate 106 shown in FIG. 1 or FIG. 2. The gate 106 may be formed of a first perovskite oxide. The gate 106 may be grown as an epitaxial thin film, with a crystal structure similar to the template layer 104.

The method proceeds with growing 706 an ABO₃ layer, e.g., the dielectric 108 or the ferroelectric 202, over the gate 106. The ABO₃ layer is second perovskite oxide having a different chemical makeup from the gate 106 and different electrical properties from the gate 106. The second perovskite oxide may be grown as an epitaxial thin film, with a crystal structure similar to the gate. The second perovskite oxide of the ABO₃ layer has a similar crystal structure to the first perovskite oxide of the gate 106.

The method proceeds with growing 708 a channel region, e.g., the channel 110 shown in FIG. 1 of FIG. 2. The channel 110 is a third perovskite oxide having a different chemical makeup and different electrical properties from the gate 106 and the second perovskite oxide of the ABO₃ layer (e.g., the dielectric 108 or the ferroelectric 202). The third perovskite oxide forming the channel 110 may be grown as an epitaxial thin film, with a crystal structure similar to the ABO₃ layer. The third perovskite oxide has a similar crystal structure to the first and second perovskite oxides of the gate 106 and the ABO₃ layer.

The method proceeds with depositing 710 S/D contacts over the channel 110, e.g., depositing the S/D contacts 112a and 112b. The S/D contacts may be formed from the same perovskite material as the gate 106 (i.e., the first perovskite oxide) or a fourth perovskite oxide. If the S/D contacts are formed from a perovskite, they may be grown as an epitaxial thin film over the channel 110. Alternatively, the S/D contacts may be formed from non-perovskite materials and deposited using, e.g., a conformal deposition or non-conformal deposition method.

The steps shown in FIG. 7 may be performed in a different order to achieve IC devices with different arrangements, e.g., any of the arrangements shown in FIGs. 4-6. For example, to form the IC device shown in FIG. 4, S/D contacts are deposited over a support structure, a channel region is grown over the S/D contacts or layer-transferred over the S/D contacts, the ABO₃ layer is grown over the channel region, and the gate is grown over the ABO₃ layer.

### Example devices

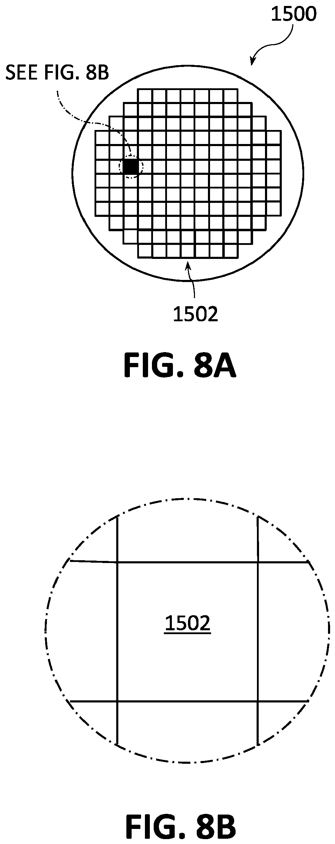

The devices formed from perovskite films disclosed herein may be included in any suitable electronic device. FIGS. 8-11 illustrate various examples of apparatuses that may include the devices formed from perovskite films disclosed herein.

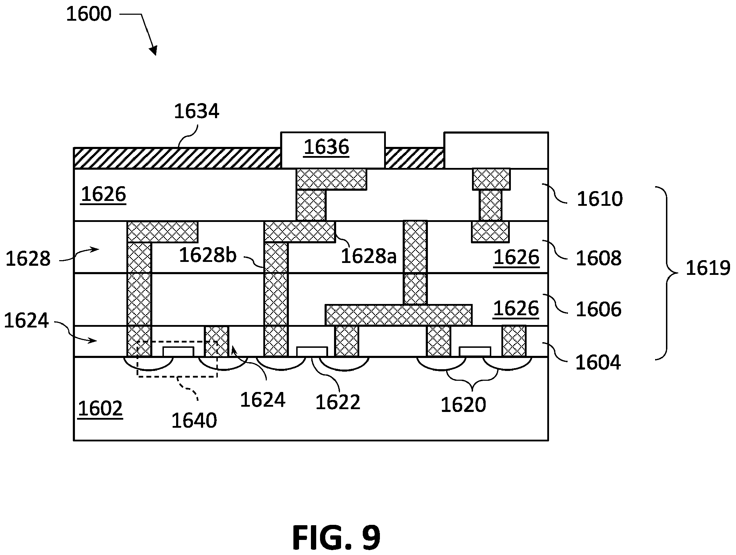

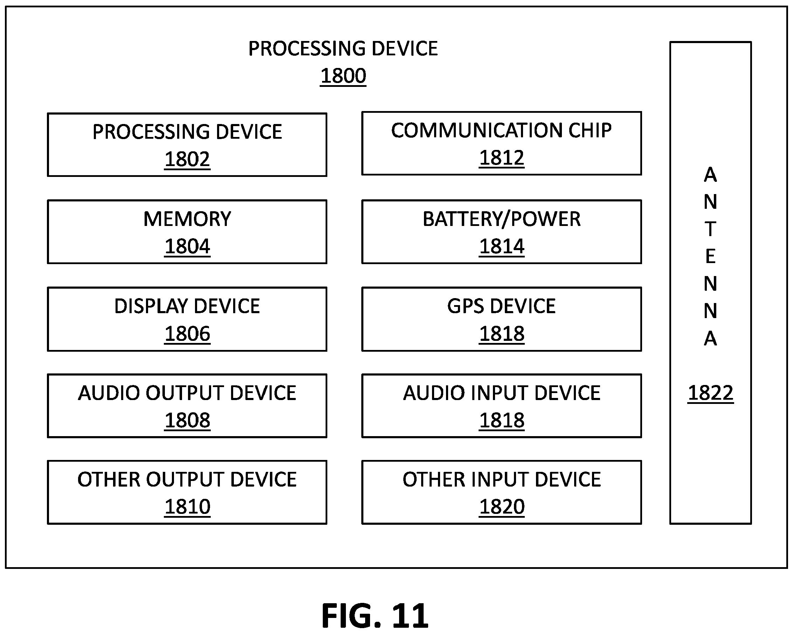

FIG. 8A and 8B are top views of a wafer and dies that include one or more IC structures with devices formed from perovskite films in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC structure (e.g., the IC structures as shown in any of FIGS. 1, 2, or 4-6, or any further embodiments of the IC structures described herein). After the fabrication of the semiconductor product is complete (e.g., after manufacture of one or more IC structures with one or more devices formed from perovskite films as described herein, included in a particular electronic component, e.g., in a transistor or in a memory device), the wafer 1500 may undergo a singulation process in which each of the dies 1502 is separated from one another to provide discrete "chips" of the semiconductor product. In particular, devices that include one or more devices formed from perovskite films as disclosed herein may take the form of the wafer 1500 (e.g., not singulated) or the form of the die 1502 (e.g., singulated). The die 1502 may include one or more transistors (e.g., one or more of the transistors 1640 of FIG. 9, discussed below) and/or supporting circuitry to route electrical signals to the transistors, as well as any other IC components (e.g., one or more devices formed from perovskite films). In some embodiments, the wafer 1500 or the die 1502 may include a memory device (e.g., an SRAM device), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 11) or other logic that is configured to store information in the memory devices or execute instructions stored in the memory array.

FIG. 9 is a cross-sectional side view of an IC device 1600 that may include one or more devices formed from perovskite films in accordance with any of the embodiments disclosed herein. The IC device 1600 may be formed on a substrate 1602 (e.g., the wafer 1500 of FIG. 8A) and may be included in a die (e.g., the die 1502 of FIG. 8B). The substrate 1602 may be any substrate as described herein. The substrate 1602 may be part of a singulated die (e.g., the dies 1502 of FIG. 8B) or a wafer (e.g., the wafer 1500 of FIG. 8A).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 9 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate electrode layer and a gate dielectric layer.

The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross section of the transistor 1640 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1640 may include one layer or a stack of layers, and the one or more layers may include silicon oxide, silicon dioxide, and/or a high-k dielectric material. The high-k dielectric material included in the gate dielectric layer of the transistor 1640 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The IC device 1600 may include one or more perovskite films at any suitable location in the IC device 1600.

The S/D regions 1620 may be formed within the substrate 1602 adjacent to the gate 1622 of each transistor 1640, using any suitable processes known in the art. For example, the S/D regions 1620 may be formed using either an implantation/diffusion process or a deposition process. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion implantation process. In the latter process, an epitaxial deposition process may provide material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620. In some embodiments, an etch process may be performed before the epitaxial deposition to create recesses in the substrate 1602 in which the material for the S/D regions 1620 is deposited.

Electrical signals, such as power and/or input/output (I/O) signals, may be routed to and/or from the transistors 1640 of the device layer 1604 through one or more interconnect layers disposed on the device layer 1604 (illustrated in FIG. 9 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form an ILD stack 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 9). Although a particular number of interconnect layers 1606-1610 is depicted in FIG. 9, embodiments of the present disclosure include IC devices having more or fewer interconnect layers than depicted.

In some embodiments, the interconnect structures 1628 may include trench contact structures 1628a (sometimes referred to as "lines") and/or via structures 1628b (sometimes referred to as "holes") filled with an electrically conductive material such as a metal. The trench contact structures 1628a may be arranged to route electrical signals in a direction of a plane that is substantially parallel with a surface of the substrate 1602 upon which the device layer 1604 is formed. For example, the trench contact structures 1628a may route electrical signals in a direction in and out of the page from the perspective of FIG. 9. The via structures 1628b may be arranged to route electrical signals in a direction of a plane that is substantially perpendicular to the surface of the substrate 1602 upon which the device layer 1604 is formed. In some embodiments, the via structures 1628b may electrically couple trench contact structures 1628a of different interconnect layers 1606-1610 together.

The interconnect layers 1606-1610 may include a dielectric material 1626 disposed between the interconnect structures 1628, as shown in FIG. 9. The dielectric material 1626 may take the form of any of the embodiments of the dielectric material provided between the interconnects of the IC structures disclosed herein.

In some embodiments, the dielectric material 1626 disposed between the interconnect structures 1628 in different ones of the interconnect layers 1606-1610 may have different compositions. In other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include trench contact structures 1628a and/or via structures 1628b, as shown. The trench contact structures 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include via structures 1628b to couple the trench contact structures 1628a of the second interconnect layer 1608 with the trench contact structures 1628a of the first interconnect layer 1606. Although the trench contact structures 1628a and the via structures 1628b are structurally delineated with a line within each interconnect layer (e.g., within the second interconnect layer 1608) for the sake of clarity, the trench contact structures 1628a and the via structures 1628b may be structurally and/or materially contiguous (e.g., simultaneously filled during a dual-damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606.

The IC device 1600 may include a solder resist material 1634 (e.g., polyimide or similar material) and one or more bond pads 1636 formed on the interconnect layers 1606-1610. The bond pads 1636 may be electrically coupled with the interconnect structures 1628 and configured to route the electrical signals of the transistor(s) 1640 to other external devices. For example, solder bonds may be formed on the one or more bond pads 1636 to mechanically and/or electrically couple a chip including the IC device 1600 with another component (e.g., a circuit board). The IC device 1600 may have other alternative configurations to route the electrical signals from the interconnect layers 1606-1610 than depicted in other embodiments. For example, the bond pads 1636 may be replaced by or may further include other analogous features (e.g., posts) that route the electrical signals to external components.

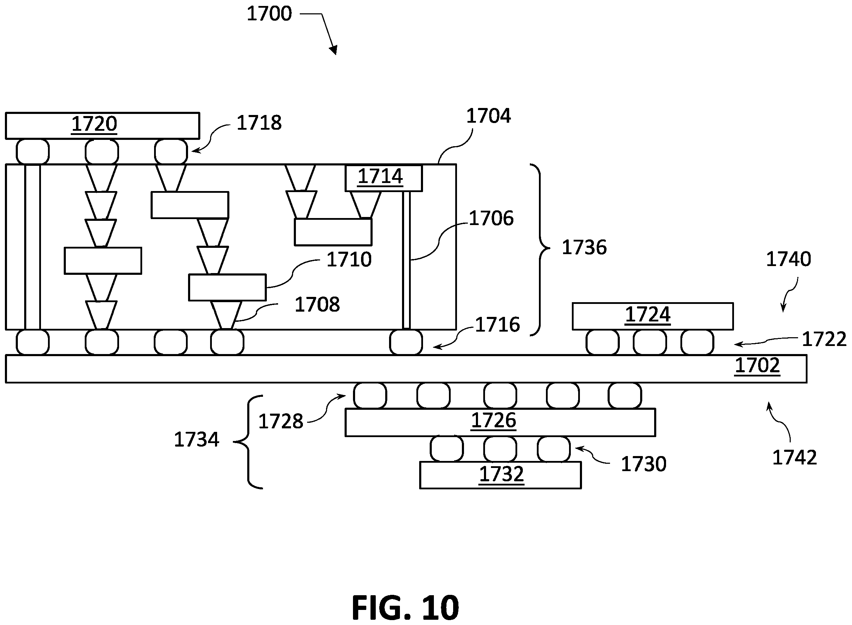

FIG. 10 is a cross-sectional side view of an IC device assembly 1700 that may include components having or being associated with (e.g., being electrically connected by means of) one or more devices formed from perovskite films in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. In particular, any suitable ones of the components of the IC device assembly 1700 may include any of the perovskite films disclosed herein.

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 10 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 10), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 10, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 8B), an IC device (e.g., the IC device 1600 of FIG. 9), or any other suitable component. In some embodiments, the IC package 1720 may include devices formed from perovskite films, as described herein. Generally, the interposer 1704 may spread a connection to a wider pitch or reroute a connection to a different connection. For example, the interposer 1704 may couple the IC package 1720 (e.g., a die) to a ball grid array (BGA) of the coupling components 1716 for coupling to the circuit board 1702. In the embodiment illustrated in FIG. 10, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

The interposer 1704 may be formed of an epoxy resin, a fiberglass-reinforced epoxy resin, a ceramic material, or a polymer material such as polyimide. In some implementations, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 10 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 11 is a block diagram of an example computing device 1800 that may include one or more components including one or more devices formed from perovskite films in accordance with any of the embodiments disclosed herein. For example, any suitable ones of the components of the computing device 1800 may include a die (e.g., the die 1502 of FIG. 8B) having devices formed from perovskite films as described herein. Any one or more of the components of the computing device 1800 may include, or be included in, an IC device 1600 (FIG. 9). Any one or more of the components of the computing device 1800 may include, or be included in, an IC device assembly 1700 (FIG. 10).

A number of components are illustrated in FIG. 11 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 11, but the computing device 1800 may include interface circuitry for coupling to the one or more components. For example, the computing device 1800 may not include a display device 1806, but may include display device interface circuitry (e.g., a connector and driver circuitry) to which a display device 1806 may be coupled. In another set of examples, the computing device 1800 may not include an audio input device 1824 or an audio output device 1808 but may include audio input or output device interface circuitry (e.g., connectors and supporting circuitry) to which an audio input device 1824 or audio output device 1808 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random-access memory (eDRAM) or spin transfer torque magnetic random-access memory (STT-MRAM).

In some embodiments, the computing device 1800 may include a communication chip 1812 (e.g., one or more communication chips). For example, the communication chip 1812 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The computing device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The computing device 1800 may include battery/power circuitry 1814. The battery/power circuitry 1814 may include one or more energy storage devices (e.g., batteries or capacitors) and/or circuitry for coupling components of the computing device 1800 to an energy source separate from the computing device 1800 (e.g., AC line power).

The computing device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display, for example.

The computing device 1800 may include an audio output device 1808 (or corresponding interface circuitry, as discussed above). The audio output device 1808 may include any device that generates an audible indicator, such as speakers, headsets, or earbuds, for example.

The computing device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The computing device 1800 may include a GPS device 1818 (or corresponding interface circuitry, as discussed above). The GPS device 1818 may be in communication with a satellite-based system and may receive a location of the computing device 1800, as known in the art.

The computing device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The computing device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1800 may be any other electronic device that processes data.

### Select examples

The following paragraphs provide various examples of the embodiments disclosed herein.

Example 1 provides an IC device having a channel region including a first perovskite oxide, the first perovskite oxide having a first lattice parameter between 3.8 and 4.3 Å; and a dielectric coupled to the channel, the dielectric including a second perovskite oxide, the second perovskite oxide having a second lattice parameter between 3.8 and 4.3 Å.

Example 2 provides the IC device of example 1, where the channel region includes strontium, titanium, and oxygen.

Example 3 provides the IC device of example 1, where the channel region further includes lanthanum.

Example 4 provides the IC device of example 1, where the channel region includes barium, tin, and oxygen.

Example 5 provides the IC device of any of the preceding examples, where the dielectric includes strontium, titanium, and oxygen.

Example 6 provides the IC device of any of the preceding examples, further including a gate, the gate including a third perovskite oxide having a third lattice parameter between 3.8 and 4.1 Å.

Example 7 provides the IC device of example 6, where the gate includes strontium and ruthenium.

Example 8 provides the IC device of example 6, where the gate includes strontium and vanadium.

Example 9 provides the IC device of any of examples 6 through 8, where the gate is over a template layer, the dielectric is over the gate, and the channel region is over the dielectric.

Example 10 provides the IC device of example 9, where the template layer includes a perovskite oxide.

Example 11 provides the IC device of any of examples 6 through 8, where the gate is over the dielectric, and the dielectric is over the channel region.

Example 12 provides the IC device of any of examples 1 through 8, where the channel region is fin-shaped, and the dielectric is over the channel region.

Example 13 provides the IC device of example 1, further including a first source or drain (S/D) contact coupled to the channel region, the first S/D contact including a third perovskite oxide having a third lattice parameter between 3.8 and 4.1 Å.

Example 14 provides an IC device having a channel region including a first perovskite oxide, the first perovskite oxide having a first lattice parameter between 3.8 and 4.3 Å; and a ferroelectric region coupled to the channel, the ferroelectric region including a second perovskite oxide, the second perovskite oxide having a second lattice parameter between 3.8 and 4.3 Å.

Example 15 provides the IC device of example 14, where the channel region includes strontium, titanium, and oxygen.

Example 16 provides the IC device of example 15, where the channel region further includes lanthanum.

Example 17 provides the IC device of example 14, where the channel region includes barium, tin, and oxygen.

Example 18 provides the IC device of any of examples 14 to 17, where the ferroelectric region includes barium, titanium, and oxygen.

Example 19 provides the IC device of any of examples 14 to 17, where the ferroelectric region includes bismuth, iron, and oxygen.

Example 20 provides the IC device of any of examples 14 to 17, where the ferroelectric region includes lutetium, iron, and oxygen.

Example 21 provides the IC device of any of examples 14 to 17, where the ferroelectric region includes lead, zirconium, titanium, and oxygen.

Example 22 provides the IC device of any of examples 14 to 21, further including a gate, the gate including a third perovskite oxide having a third lattice parameter between 3.8 and 4.1 Å.

Example 23 provides the IC device of example 22, where the gate includes strontium and ruthenium.

Example 24 provides the IC device of example 22, where the gate includes strontium and vanadium.

Example 25 provides the IC device of any of examples 22 through 24, where the gate is over a template layer, the ferroelectric region is over the gate, and the channel region is over the ferroelectric region.

Example 26 provides the IC device of example 25, where the template layer includes a perovskite oxide.

Example 27 provides the IC device of any of examples 22 through 24, where the gate is over the ferroelectric region, and the ferroelectric region is over the channel region.

Example 28 provides the IC device of example 14, further including a first source or drain (S/D) contact coupled to the channel region, the first S/D contact including a third perovskite oxide having a third lattice parameter between 3.8 and 4.1 Å.

Example 29 provides a method for fabricating an IC device including forming a gate over a template layer, the gate including a first perovskite oxide; forming a high-k region over the gate, the high-k region including a second perovskite oxide; and forming a channel region over the high-k region, the channel region including a third perovskite oxide having a first lattice parameter between 3.8 and 4.3 Å.

Example 30 provides the method of example 29, where the high-k region is a high-k dielectric.

Example 31 provides the method of example 29, where the high-k region is a ferroelectric.

Example 32 provides the method of any of examples 29 through 31, where the second perovskite oxide has a second lattice parameter between 3.8 and 4.3 Å.

Example 33 provides an IC device having a channel region including a first perovskite oxide, the first perovskite oxide including barium, tin, and oxygen; and a dielectric coupled to the channel, the dielectric including a second perovskite oxide, the second perovskite oxide including strontium, titanium, and oxygen.

Example 34 provides the IC device of example 33, further including a gate, the gate including strontium.

Example 35 provides the IC device of example 34, where the gate further includes ruthenium.

Example 36 provides the IC device of example 34, where the gate further includes vanadium.

Example 37 provides the IC device of any of examples 34 through 36, where the gate is over a template layer, the dielectric is over the gate, and the channel region is over the dielectric.

Example 38 provides the IC device of example 37, where the template layer includes a perovskite oxide.

Example 39 provides the IC device of any of examples 34 through 36, where the gate is over the dielectric, and the dielectric is over the channel region.

Example 40 provides the IC device of any of examples 33 through 38, where the channel region is fin-shaped, and the dielectric is over the channel region.

Example 41 provides the IC device of example 33, further including a first source or drain (S/D) contact coupled to the channel region, the first S/D contact including a third perovskite oxide.

Example 42 provides an IC device having a channel region including a first perovskite oxide, the first perovskite oxide including strontium, titanium, and oxygen; and a dielectric coupled to the channel, the dielectric including a second perovskite oxide, the second perovskite oxide including strontium, titanium, and oxygen.

Example 43 provides the IC device of example 42, where the first perovskite oxide further includes a dopant, e.g., lanthanum.

Example 44 provides the IC device of example 42 or 43, further including a gate, the gate including strontium.

Example 45 provides the IC device of example 44, where the gate further includes ruthenium.

Example 46 provides the IC device of example 44, where the gate further includes vanadium.

Example 47 provides the IC device of any of examples 44 through 46, where the gate is over a template layer, the dielectric is over the gate, and the channel region is over the dielectric.

Example 48 provides the IC device of example 47, where the template layer includes a perovskite oxide.

Example 49 provides the IC device of any of examples 44 through 46, where the gate is over the dielectric, and the dielectric is over the channel region.

Example 50 provides the IC device of any of examples 42 through 48, where the channel region is fin-shaped, and the dielectric is over the channel region.

Example 51 provides the IC device of example 42, further including a first source or drain (S/D) contact coupled to the channel region.

Example 52 provides the IC device of example 51, the first S/D contact including a third perovskite oxide.

Example 53 provides an IC package that includes an IC die, including one or more of the IC devices according to any one of the preceding examples. The IC package may also include a further component, coupled to the IC die.

Example 54 provides the IC package according to example 53, where the further component is one of a package substrate, a flexible substrate, or an interposer.

Example 55 provides the IC package according to examples 53 or 54, where the further component is coupled to the IC die via one or more first level interconnects.

Example 56 provides the IC package according to example 55, where the one or more first level interconnects include one or more solder bumps, solder posts, or bond wires.

Example 57 provides a computing device that includes a circuit board; and an IC die coupled to the circuit board, where the IC die includes one or more of the memory/IC devices according to any one of the preceding examples (e.g., memory/IC devices according to any one of examples 1-52), and/or the IC die is included in the IC package according to any one of the preceding examples (e.g., the IC package according to any one of examples 53-56).

Example 58 provides the computing device according to example 57, where the computing device is a wearable computing device (e.g., a smart watch) or hand-held computing device (e.g., a mobile phone).

Example 59 provides the computing device according to examples 57 or 58, where the computing device is a server processor.

Example 60 provides the computing device according to examples 57 or 58, where the computing device is a motherboard.

Example 61 provides the computing device according to any one of examples 57-60, where the computing device further includes one or more communication chips and an antenna.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device comprising:
a channel region comprising a first perovskite oxide, the first perovskite oxide having a first lattice parameter between 3.8 and 4.3 Å; and
a ferroelectric region coupled to the channel, the ferroelectric region comprising a second perovskite oxide, the second perovskite oxide having a second lattice parameter between 3.8 and 4.3 Å.

2. The IC device of claim 1, wherein the channel region comprises strontium, titanium, and oxygen.

3. The IC device of claim 2, wherein the channel region further comprises lanthanum.

4. The IC device of claim 1, wherein the channel region comprises barium, tin, and oxygen.

5. The IC device of claim 1, wherein the ferroelectric region comprises barium, titanium, and oxygen.

6. The IC device of claim 1, wherein the ferroelectric region comprises bismuth, iron, and oxygen.

7. The IC device of claim 1, wherein the ferroelectric region comprises lutetium, iron, and oxygen.

8. The IC device of claim 1, wherein the ferroelectric region comprises lead, zirconium, titanium, and oxygen.

9. The IC device of any one of claims 1-8, further comprising a gate, the gate comprising a third perovskite oxide having a third lattice parameter between 3.8 and 4.1 Å.

10. The IC device of claim 9, wherein the gate comprises strontium.

11. The IC device of any one of claims 9-10, wherein the gate is over a template layer comprising a perovskite oxide, the ferroelectric region is over the gate, and the channel region is over the ferroelectric region.

12. The IC device of any one of claims 1-11, wherein where the channel region is fin-shaped, and the dielectric is over the channel region.

13. The IC device of claim 1, further comprising a first source or drain (S/D) contact coupled to the channel region, the first S/D contact comprising a third perovskite oxide having a third lattice parameter between 3.8 and 4.1 Å.

14. A method for fabricating an integrated circuit (IC) device comprising:
forming a gate over a template layer, the gate comprising a first perovskite oxide;
forming a high-k region over the gate, the high-k region comprising a second perovskite oxide; and
forming a channel region over the high-k region, the channel region comprising a third perovskite oxide having a first lattice parameter between 3.8 and 4.3 Å.

15. The method of claim 14, wherein the high-k region is a ferroelectric having a second lattice parameter between 3.8 and 4.3 Å.
